# EUROPEAN PATENT APPLICATION

(11) **EP 4 560 046 A1**
(43) Date of publication of application: **28.05.2025**
(21) Application number: 23860026.6
(22) Date of filing: 14.08.2023
(51) Int. Cl.: C23C 14/02, H05H 1/46

(54) **ION BOMBARDMENT DEVICE AND ION BOMBARDMENT PROCESSING METHOD**

(30) Priority: 29.08.2022 JP 2022136146
(71) Applicant: KABUSHIKI KAISHA KOBE SEIKO SHO (KOBE STEEL, LTD.), Hyogo 651-8585 (JP)
(72) Inventor: TAKAHASHI, Tetsuya, Takasago-shi, Hyogo 676-8670 (JP); TAKEI, Ryosuke, Takasago-shi, Hyogo 676-8670 (JP)
(74) Representative: TBK
(86) International application number: PCT/JP2023/029478
(87) International publication number: WO 2024/048261

(57) **Abstract**

An ion bombardment device (1) includes a vacuum chamber (2), a substrate support (11), a filament (3), a discharge power source (22), a filament heating power source (3T), and a magnetic field generating mechanism (20). The filament (3) has one end (31) and an other end (32). The magnetic field generating mechanism (20) includes a first magnetic field generator (201) that generates a first magnetic field in a region incorporating the one end (31) of the filament (3) and a second magnetic field generator (202) that generates a second magnetic field in a region incorporating the other end (32) of the filament (3). The first magnetic field and the second magnetic field increase plasma around the ends of the filament (3), resulting in reducing variation in plasma densities and reduce variation in etching amounts.

## Description

### Technical Field

The present invention relates to an ion bombardment device and an ion bombardment processing method for cleaning a surface of a substrate.

### Background Art

Generally, a hard coating is deposited onto a surface of a substrate which is a coating target by a physical vapor deposition (PVD) way or a chemical vapor deposition (CVD) way to improve the wear resistance of a cutting tool or to increase slidability of a sliding surface of a mechanical component. Example of an apparatus for such deposition of a hard coating include a physical vapor deposition apparatus, such as an arc ion plating apparatus and a sputtering apparatus, and a chemical vapor deposition apparatus, such as a plasma CVD apparatus.

Purifying or cleaning of a surface of the substrate prior to the coating deposition has been known to achieve the deposition of the hard coating with high adherence by such a physical vapor deposition apparatus and a chemical vapor deposition apparatus. Examples of the purification include a method (ion bombardment method) of generating heavy inert gas ions like argon ions through plasma discharge, emitting the ions onto the substrate and heating a surface of the substrate, and cleaning the surface.

Patent Literature 1 discloses an ion bombardment device that is configured to clean a surface of a substrate within a vacuum chamber as a technology of the purification. The ion bombardment device includes an electrode, a plurality of anodes, and a discharge power source each located in a vacuum chamber, the electrode being disposed near a face of an inner wall of the vacuum chamber to emit electrons, the anodes facing the electrode across a processing space relative to the substrate and disposed near the face of the inner wall to receive the electrons from the electrode, and the discharge power source applying a discharge voltage between the electrode and the anodes. The electrode is formed of a filament extending in an up-down direction, and the anodes are mutually spaced in the up-down direction. When the discharge voltage is applied, the electrode emits electrons and plasma is generated between the electrode and the anodes. As a result, argon ions generated in the plasma collide with the substrate having a negative bias voltage to clean the surface of the substrate.

### Citation List

### Patent Literature

Patent Literature 1: Japanese Unexamined Patent Publication No. 2014-152356

Cleaning the surface of the substrate by the device described in Patent Literature 1 has a disadvantage of large variation in etching amounts (cutting or carving amounts) on the surface of the substrate. Specifically, in the above-described technology, the filament has an upper end and a lower end respectively connected to filament electrodes and the filament receives a flow of a heating electric current through the electrodes, so that the filament is heated and emits electrons. In this configuration, a central part of the filament is likely to have a higher temperature than a temperature of each of the upper end and the lower end thereof. Besides, a central part of the vacuum chamber in the up-down direction has a higher plasma density than a plasma density in a lower part of the vacuum chamber and a plasma density in an upper part of the vacuum chamber. This results in a high likelihood of making a difference in etching amounts on the surface of the substrate attributed to the ion collision between a central part of the substrate, and the upper part and the lower part of the substrate in the up-down direction. In this case, etching in the central part of the substrate having the higher plasma density therearound may lead to excessive etching on the surface of the substrate. In contrast, etching in the upper part and the lower part each having the lower plasma density therearound may lead to unsatisfactory etching on the surface of the substrate without reaching a predetermined etching amount.

Further, possible variation in the etching amounts on the substrate as described above in deposition of a coating onto the substrate after cleaning may lead a failure at depositing the hard coating on the surface of the substrate with a uniform density. This makes it difficult to improve the wear resistance of the substrate or other properties thereof.

### Summary of Invention

An object of the present invention is to provide an ion bombardment device and an ion bombardment processing method for a reduction in variation in etching amounts on a surface of a substrate by reducing variation in plasma densities in a vacuum chamber in an apparatus including a filament serving as an electrode.

The present invention provides an ion bombardment device that is configured to clean a surface of a substrate by irradiating the surface with ions. The ion bombardment device includes a vacuum chamber, a substrate support, at least one filament, an anode, a discharge power source, a filament heating power source, and at least one magnetic field generating mechanism. The vacuum chamber defines an inner space inside the vacuum chamber. The substrate support is located in the inner space to support the substrate. The at least one filament extends in a predetermined extension direction in the inner space and faces the substrate. The at least one filament has one end and an other end opposite to the one end in the extension direction. The anode is exposed to at least the inner space. The discharge power source applies a discharge voltage between the at least one filament and the anode. The filament heating power source heats the filament by applying a heating voltage between the one end and the other end of the at least one filament. The at least one magnetic field generating mechanism is located opposite the substrate across the filament. The at least one magnetic field generating mechanism includes a first magnetic field generator that generates a first magnetic field in a region incorporating the one end of the at least one filament and a second magnetic field generator that generates a second magnetic field in a region incorporating the other end of the at least one filament.

The present invention provides an ion bombardment processing method for cleaning a surface of a substrate. The ion bombardment processing method includes: supporting the substrate by a substrate support located in an inner space of a vacuum chamber; arranging at least one filament to extend in a predetermined extension direction in the inner space and face the substrate; providing at least one magnetic field generating mechanism to be located opposite the substrate across the at least one filament, the at least one magnetic field generating mechanism including a first magnetic field generator that generates a first magnetic field in a region incorporating one end of the at least one filament and a second magnetic field generator that generates a second magnetic field in a region incorporating an other end of the at least one filament opposite to the one end in the extension direction; heating the at least one filament by applying a heating voltage between the one end and the other end of the at least one filament; generating plasma by applying a discharge voltage between an anode exposed to at least the inner space and the at least one filament; and cleaning the surface of the substrate by irradiating the surface with ions contained in the plasma while increasing a density of the plasma around each of the one end and the other end of the at least one filament in at least the first magnetic field and the second magnetic field.

### Brief Description of Drawings

Fig. 1 is a side cross-sectional view of an ion bombardment device according to an embodiment of the present invention.
Fig. 2 is a planar cross-sectional view of the ion bombardment device according to the embodiment of the present invention.
Fig. 3 is an enlarged side cross-sectional view of the ion bombardment device according to the embodiment of the present invention.
Fig. 4 is a graph showing a distribution of etching amounts of a substrate in each of Example 1 in the present invention and Comparative Example 1.
Fig. 5 is a graph showing a distribution of etching amounts of a substrate in each of Example 1 and Example 2 in the present invention.
Fig. 6 is a graph showing a distribution of etching amounts of a substrate in each of Example 2 and Example 3 in the present invention.
Fig. 7 is a graph showing a distribution of etching amounts of a substrate in each of Example 3 and Example 4 in the present invention.
Fig. 8 is a graph showing a distribution of etching amounts of a substrate in each of Example 3 in the present invention and Comparative Example 1.
Fig. 9 is a graph showing a distribution of etching amounts of a substrate in each of Comparative Example 1 and Comparative Example 2 to be compared with each Example in the present invention.
Fig. 10 is a plan view of a magnetic field distribution around the substrate in each Example in the present invention.
Fig. 11 is a side cross-sectional view of an ion bombardment device according to a modified embodiment of the present invention.

### Description of Embodiments

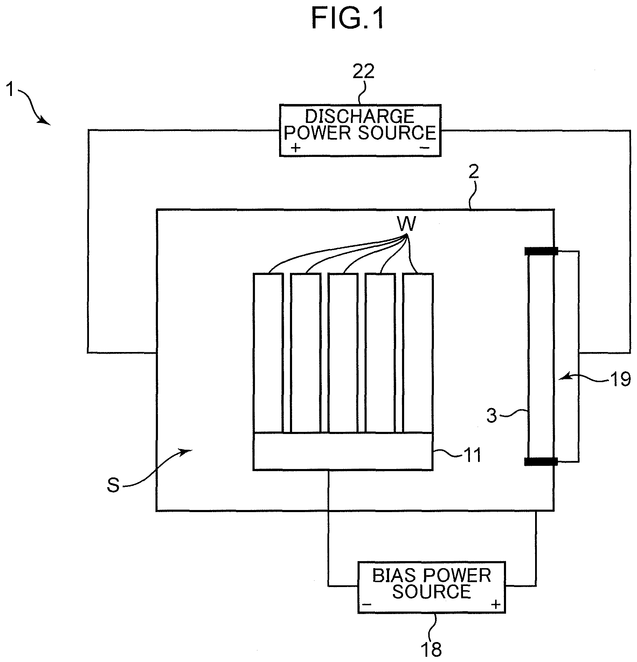

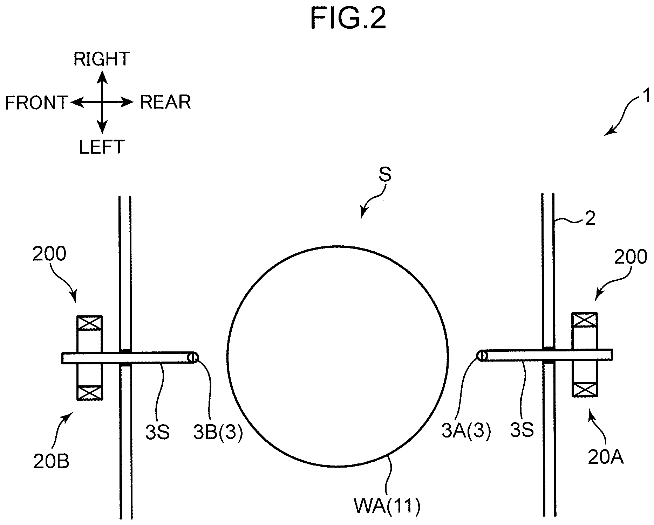

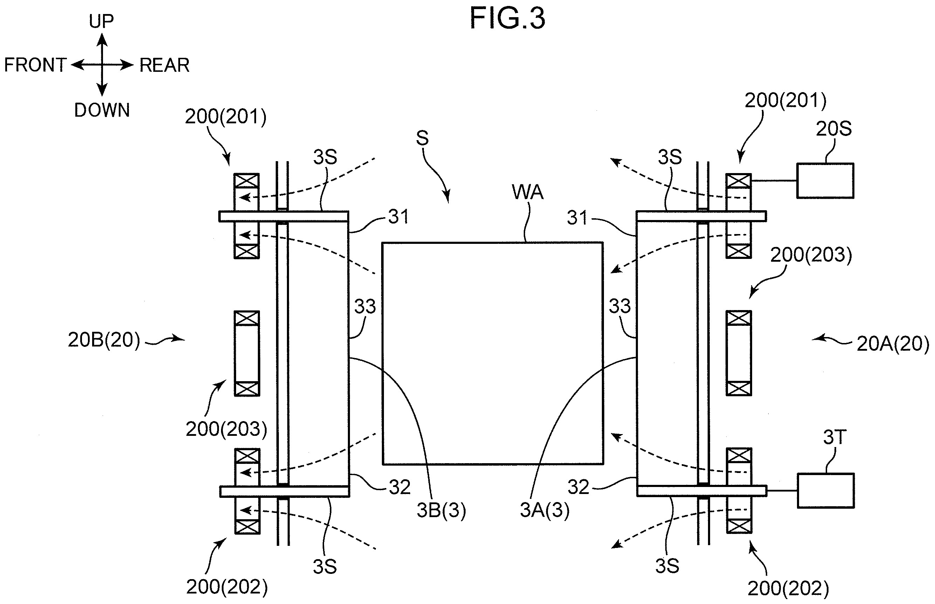

Hereinafter, an embodiment of the present invention will be described with reference to the accompanying drawings. Fig. 1 is a side cross-sectional view of an ion bombardment device 1 according to the embodiment. Fig. 2 is a planar cross-sectional view of the ion bombardment device 1. Fig. 3 is an enlarged side cross-sectional view of the ion bombardment device 1. The ion bombardment device 1 is configured to clean a surface of a workpiece W or substrate by irradiating the surface with ions. The ion bombardment device 1 illustrated in each drawing merely shows an example of the ion bombardment device according to the embodiment, and thus, the ion bombardment device according to the present invention is not limited to the device illustrated in each drawing. For instance, the ion bombardment device 1 is configured to clean or purify a surface of a workpiece W made of stainless.

The ion bombardment device 1 includes: a vacuum chamber 2; a rotatable table 11 or substrate support; a bias power source 18; a plasma generator 19 including a filament 3 and a discharge power source 22; a filament heating power source 3T; and a magnetic field generating mechanism 20.

The vacuum chamber 2 accommodates the rotatable table 11 and a plurality of workpieces W arranged on the rotatable table 11. Although not illustrated in Fig. 1, a plurality of workpiece holders may be fixed on the rotatable table 11, and the workpiece holders may support the workpieces W respectively. The vacuum chamber 2 defines inside an inner space S having a cylindrical shape with a center line extending in the up-down direction.

The inner space S of the vacuum chamber 2, that is, a space accommodating the rotatable table 11 and the workpieces W, is kept in a vacuum state or a nearly vacuum state by an unillustrated vacuum pump in each of a vacuuming step, a heating step, and an etching step to be described later. Although not illustrated in the drawings, the vacuum chamber 2 has an inlet for introducing argon gas serving as inert gas used in the etching step into the vacuum chamber 2 and an outlet for discharging the argon gas from the inside to the outside of the vacuum chamber 2.

The rotatable table 11 is located in the inner space of the vacuum chamber 2 to support the workpieces W. In the embodiment, the rotatable table 11 has a disc shape in a plan view (Fig. 2). The rotatable table 11 rotates about its central axis while supporting the workpieces W in the etching step. The rotatable table 11 may further include rotatable bases respectively for the workpieces W to be arranged thereon in such a manner that the workpieces W are independently rotatable. A region occupied by the workpieces W supported on the rotatable table 11 in the inner space S of the vacuum chamber 2 is referred to as a processing space WA (Fig. 3).

The bias power source 18 applies a negative bias voltage to each of the workpieces W via the rotatable table 11. The negative bias voltage is applied in the etching step.

The plasma generator 19 includes the filament 3 and the discharge power source 22. The plasma generator 19 generates plasma in the inner space of the vacuum chamber 2.

The filament 3 extends in an up-down direction or predetermined extension direction in the inner space S of the vacuum chamber 2 and faces the workpieces W on the rotatable table 11. Although Fig. 1 illustrates one filament 3, one set of two filaments 3 is arranged in the embodiment as shown in Fig. 2 and Fig. 3. Specifically, the filament 3 includes a first filament 3A and a second filament 3B. The second filament 3B is arranged in such a manner that the workpieces W on the rotatable table 11 are placed between the first filament 3A and the second filament 3B in a direction (in a front-rear direction in the embodiment) perpendicularly intersecting the up-down direction. In other words, in the embodiment, the first filament 3A and the second filament 3B located opposite each other at a distance therebetween with an angle of 180° in a circumferential direction across the rotatable table 11 having the disc shape. As illustrated in Fig. 3, each of the first filament 3A and the second filament 3B has a dimension in the up-down direction that is longer than a dimension of the processing space WA in the up-down direction in such a manner that the processing space WA falls within an extent of each of the first filament 3A and the second filament 3B in the up-down direction.

As illustrated in Fig. 3, each filament 3 (each of the first filament 3A and the second filament 3B) has an upper end 31 (one end), a lower end 32 (an other end opposite to the one end in the extension direction of the filament 3), and an intermediate part 33 located between the upper end 31 and the lower end 32. Each filament 3 serves as a cathode. For instance, as illustrated in Fig. 3, the upper end 31 is located near an upper end defining the processing space WA and the lower end 32 is located near a lower end defining the processing space WA.

In contrast, the vacuum chamber 2 serves as an anode in the embodiment. An inner wall face of the vacuum chamber 2 is exposed to the inner space S, enabling it to act as the anode. It is noted here that another anode may be provided in the inner space S of the vacuum chamber 2 as described later.

The discharge power source 22 applies a discharge voltage between each filament 3 and the vacuum chamber 2 serving as the anode to generate plasma in the inner space S.

The filament heating power source 3T heats each filament 3 (each of the first filament 3A and the second filament 3B) by applying a heating voltage between the upper end 31 and the lower end 32 of the filament 3. As illustrated in Fig. 3, a pair of filament electrodes 3S or electrodes are respectively connected to the upper end 31 and the lower end 32. Although Fig. 3 schematically illustrates the filament heating power source 3T, the filament heating power source 3T is electrically connected to the pair of filament electrodes 3S to apply the heating voltage to the filament 3. As an example, Fig. 3 illustrates one of the filament electrodes 3S at a higher position than the upper end defining the processing space WA and the other of the filament electrodes 3S at a lower position than the lower end defining the processing space WA in the up-down direction.

Glow discharge is generated in the plasma generator 19 in response to application of the discharge voltage from the discharge power source 22 to each filament 3. The glow discharge allows plasma based on the argon gas introduced into the inner space S of the vacuum chamber 2 to be generated around each filament 3. Argon ions or inert gas ions contained in the plasma are accelerated to move toward the workpieces W facing the filament 3 by the application of the negative bias voltage to each of the workpieces W. This results in allowing the argon ions to collide with the workpieces W. It is noted here that the filament heating power source 3T heats each filament 3 to allow the filament 3 to emit electrons or thermal electrons therefrom, and the discharge is maintained.

The magnetic field generating mechanism 20 generates a magnetic field around each filament 3 to increase a density of the plasm generated around the filament 3 and improve uniformity of a distribution of the plasma. In the embodiment, the magnetic field generating mechanism 20 includes a first magnetic field generating mechanism 20A and a second magnetic field generating mechanism 20B. The first magnetic field generating mechanism 20A generates a magnetic field around the first filament 3A. The second magnetic field generating mechanism 20B is arranged in such a manner that the workpieces W are placed between the first magnetic field generating mechanism 20A and the second magnetic field generating mechanism 20B in a direction perpendicularly intersecting the up-down direction, and generates a magnetic field around the second filament 3B. The magnetic field generating mechanism 20 may include only the first magnetic field generating mechanism 20A without the second magnetic field generating mechanism 20B. In this regard, however, the arrangement of both the first magnetic field generating mechanism 20A and the second magnetic field generating mechanism 20B enables acceleration in processing onto the workpieces W. The arrangement of the mechanisms further leads to a success in providing a longer time period for contact of the workpieces W with the plasma during rotation of the rotatable table 11 and thus preventing even slight impurities existing in the inner space S from adhering to the workpieces W.

Each magnetic field generating mechanism 20 (each of the first magnetic field generating mechanism 20A and the second magnetic field generating mechanism 20B) is located opposite the workpieces W across the associated filament 3. Specifically, the first magnetic field generating mechanism 20A is located opposite the workpieces W across the first filament 3A. The second magnetic field generating mechanism 20B is located opposite the workpieces W across the second filament 3B. In other words, each magnetic field generating mechanism 20 is located behind the associated filament 3 in a view from the workpieces W.

Each magnetic field generating mechanism 20 includes a plurality of electromagnetic coils 200 and a coil power source 20S. Specifically, each magnetic field generating mechanism 20 includes an upper electromagnetic coil 201 or first magnetic field generator, a lower electromagnetic coil 202 or second magnetic field generator, and a middle electromagnetic coil 203 or middle magnetic field generator. The coil power source 20S generates a magnetic field around each filament 3 by supplying a flow of an electric current to each electromagnetic coil. In the embodiment, each electromagnetic coil 200 is arranged outside the vacuum chamber 2, and generates a magnetic field in the inner space S via the vacuum chamber 2. In another embodiment, each electromagnetic coil 200 may be arranged in the inner space S. A plurality of middle magnetic field generators each exemplified by the middle electromagnetic coil 203 may be provided.

The upper electromagnetic coil 201 generates a first magnetic field in a region incorporating the upper end 31 of the associated filament 3. The lower electromagnetic coil 202 generates a second magnetic field in a region incorporating the lower end 32 of the associated filament 3. The middle electromagnetic coil 203 is located between the upper electromagnetic coil 201 and the middle electromagnetic coil 203 in the up-down direction, and generates a middle magnetic field in a region incorporating the intermediate part 33 of the associated filament 3. Although Fig. 3 illustrates connection of the coil power source 20S only to the upper electromagnetic coil 201 of the first magnetic field generating mechanism 20A, the coil power source 20S is connected to each electromagnetic coil of the first magnetic field generating mechanism 20A and the second magnetic field generating mechanism 20B, and further allows the electric current to flow in a predetermined direction depending on a polarity of each associated magnetic field. Alternatively, each electromagnetic coil may be provided with an independent coil power source.

Further, each of the upper electromagnetic coil 201, the lower electromagnetic coil 202, and the middle electromagnetic coil 203 has a center line extending in a direction (the front-rear direction), perpendicularly intersecting the up-down direction, in which the corresponding electromagnetic coil 200 and the workpieces W are connected. Each electromagnetic coil is formed of unillustrated coil wires wound about the center line. In the embodiment, as illustrated in Fig. 3, the upper electromagnetic coil 201 and the lower electromagnetic coil 202 in each magnetic field generating mechanism 20 are arranged to surround the pair of filament electrodes 3S respectively. This enables accurate formation of magnetic fields respectively around the upper end 31 and the lower end 32 relative to the filament electrodes 3S respectively connected to the ends of the filament 3.

In the embodiment, as an example, a polarity of the upper electromagnetic coil 201, a polarity of the lower electromagnetic coil 202, and a polarity of the middle electromagnetic coil 203 in each electromagnetic coil 200 are same. In Fig. 3, the upper electromagnetic coil 201 of the first magnetic field generating mechanism 20A forms a magnetic force line extending forward over the upper end 31 of the first filament 3A. The lower electromagnetic coil 202 forms a magnetic force line in a similar manner. The middle electromagnetic coil 203 forms a magnetic force line in a similar manner even without an illustration of a direction of the magnetic force line.

In Fig. 3, the upper electromagnetic coil 201 of the second magnetic field generating mechanism 20B also forms a magnetic force line extending forward over the upper end 31 of the second filament 3B. The lower electromagnetic coil 202 forms a magnetic force line in a similar manner. The middle electromagnetic coil 203 forms a magnetic force line in a similar manner even without an illustration of a direction of the magnetic force line. In this case, in a view from the workpieces W arranged in the processing space WA, the magnetic force line formed by each electromagnetic coil 200 of the first magnetic field generating mechanism 20A faces in a direction opposite to a direction in which the magnetic force line formed by each electromagnetic coil 200 of the second magnetic field generating mechanism 20B faces. In other words, in the example illustrated in Fig. 3, the polarities of the three electromagnetic coils 200 of the first magnetic field generating mechanism 20A in the up-down direction are same, and the polarities of the three electromagnetic coils 200 of the second magnetic field generating mechanism 20B in the up-down direction are same. In contrast, the polarities of the electromagnetic coils 200 differ from each other (are opposite to each other) between the first magnetic field generating mechanism 20A and the second magnetic field generating mechanism 20B.

However, the relation between or among the polarities of the electromagnetic coils 200 of each magnetic field generating mechanism 20 is not limited to the foregoing. A more preferable polarity and a magnitude relation of magnetic forces between or among the electromagnetic coils 200 will be described in detail in Examples later.

Next, ion bombardment processing steps for the ion bombardment device 1 will be briefly described. An ion bombardment processing method according to the present invention includes a preparation step, the vacuuming step, the heating step, and the etching step.

First, the preparation step is executed by setting workpieces W on the rotatable table 11 in the vacuum chamber 2. As described above, in the preparation step, a plurality of workpiece holders may support the workpieces W respectively, and thereafter, the workpiece holders may be disposed on the rotatable table 11.

The vacuuming step is executed when the preparation step is finished. The vacuuming step includes keeping the inside of the vacuum chamber 2 in a vacuum state or a nearly vacuum state by an unillustrated vacuum pump. The vacuum chamber 2 has an internal pressure of, for example, 0.0001 Pa to 0.01 Pa in the vacuuming step.

The heating step is executed when the vacuuming step is finished. The heating step includes heating each of the workpieces W at a predetermined temperature for a predetermined time period. Each of the workpieces W has a temperature of, for example, 50°C to 300°C in the heating step. Each of the workpiece W is heated for a heating time period of, for example, 0.5 to 2 hours in the heating step.

The etching step is executed after the heating step is finished. The etching step includes etching the surface of each of the workpieces W. Specifically, the etching step is executed in a manner described below.

First, argon gas is introduced into the vacuum chamber 2. An amount of the argon gas to be introduced into the vacuum chamber 2 is, for example, 50 ml/min to 500 ml/min. At this time, the vacuum chamber 2 has an internal pressure of, for example, 0.5 Pa to 2.0 Pa.

A glow discharge is generated between the vacuum chamber 2 and each filament 3 by heating the filament 3 by the filament heating power source 3T and applying a high voltage from the discharge power source 22 to the filament 3 while introducing the argon gas into the vacuum chamber 2. The high voltage applied to the filament 3 is, for example, 40 V to 100 V. Heating the filament 3 encourages emission of thermal electrons for the glow discharge.

The glow discharge allows plasma based on the argon gas to be generated around the filament 3. The plasma contains argon ions. Applying a negative bias voltage by the bias power source 18 in this state accelerates the argon ions in the plasma to move toward the workpieces W located in front of (radially inward from) the filament 3. The argon ions hence can collide with the workpieces W. This consequently enables etching of the surface of each of the workpieces W.

In particular, in the embodiment, each magnetic field generating mechanism 20 is located behind the associated filament 3 in a view from the workpieces W. Each electromagnetic coil 200 of the magnetic field generating mechanism 20 forms a strong magnetic field around the associated filament 3, particularly, around each of the upper end 31 and the lower end 32. In the filament 3 having been heated by receiving the electric current from the filament heating power source 3T, the intermediate part 33 is likely to have a higher temperature than a temperature of each of upper end 31 and the lower end 32. As a result, a plasma density around a central part of the filament 3 is likely to be higher. However, the operational effect of each magnetic field described above increases plasma densities respectively around the upper end 31 and the lower end 32, and thus, a more uniform plasma distribution with less variation is attained in the up-down direction, that is, in the extension direction of the filament 3. This consequently leads to achievement in reducing variation in etching amounts, in the up-down direction, of the workpieces W arranged on the rotatable table 11 in the processing space WA. Additionally, the arrangement of the middle electromagnetic coil 203 between the upper electromagnetic coil 201 and the lower electromagnetic coil 202 prevents a relative reduction in a plasma density around the intermediate part 33 due to influences of the upper electromagnetic coil 201 and the lower electromagnetic coil 202, and thus can lead to a further reduction in variation in plasma densities.

### Examples

Next, the embodiment of the present invention described above will be further described with reference to Examples. However, the present invention should not be limited to Examples to be described below. In each test, under the test conditions described below, etching processing (ion bombardment processing) was executed onto workpieces W for a predetermined time period.

### Comparison tests

### Example 1 (formation of upper and lower magnetic fields with the same pole)

The first magnetic field generating mechanism 20A was arranged inside the vacuum chamber 2. The upper electromagnetic coil 201 and the lower electromagnetic coil 202 formed their respective magnetic fields each having a specific same pole, i.e., S-pole, around an associated filament 3. An electric current of 8A was caused to flow in each of the upper electromagnetic coil 201 and the lower electromagnetic coil 202. No electric current was caused to flow in the middle electromagnetic coil 203, and thus, the middle electromagnetic coil 203 did not form a magnetic field.

### Example 2 (formation of upper, middle, and lower magnetic fields with the same pole)

The first magnetic field generating mechanism 20A was arranged inside the vacuum chamber 2. The upper electromagnetic coil 201, the lower electromagnetic coil 202, and the middle electromagnetic coil 203 formed their respective magnetic fields each having a specific same pole, i.e., S-pole, around an associated filament 3. An electric current of 8A was caused to flow in each of the upper electromagnetic coil 201, the lower electromagnetic coil 202, and the middle electromagnetic coil 203. In this case, the upper electromagnetic coil, the lower electromagnetic coil, and the middle electromagnetic coil were defined to have the same coil winding number even without particular limitation.

### Example 3 (formation of upper, middle, lower magnetic fields with the same pole, weaker middle magnetic field)

The first magnetic field generating mechanism 20A was arranged inside the vacuum chamber 2. The upper electromagnetic coil 201, the lower electromagnetic coil 202, and the middle electromagnetic coil 203 formed their respective magnetic fields each having a specific same pole, i.e., S-pole, around an associated filament 3. An electric current of 8A was caused to flow in each of the upper electromagnetic coil 201 and the lower electromagnetic coil 202, and an electric current of 4A was caused to flow in the middle electromagnetic coil 203. In this case, the upper electromagnetic coil, the lower electromagnetic coil, and the middle electromagnetic coil were defined to have the same coil winding number even without particular limitation.

### Example 4 (formation of upper and lower magnetic fields with the same pole and a weaker middle magnetic field with a different pole)

The first magnetic field generating mechanism 20A was arranged inside the vacuum chamber 2. The upper electromagnetic coil 201 and the lower electromagnetic coil 202 formed their respective magnetic fields each having a specific same pole, i.e., S-pole, around an associated filament 3, and the middle electromagnetic coil 203 formed a magnetic field having a different pole, i.e., N-pole, from the pole of each of the upper electromagnetic coil 201 and the lower electromagnetic coil 202. An electric current of 8A was caused to flow in each of the upper electromagnetic coil 201 and the lower electromagnetic coil 202, and an electric current of 4A was caused to flow in the middle electromagnetic coil 203. In this case, the upper electromagnetic coil, the lower electromagnetic coil, and the middle electromagnetic coil were defined to have the same coil winding number even without particular limitation.

### Comparative Example 1 (no magnetic field)

The ion bombardment processing was executed without arranging the first magnetic field generating mechanism 20A inside the vacuum chamber 2.

### Comparative Example 2 (only a middle magnetic field formed, no upper and lower magnetic fields)

The first magnetic field generating mechanism 20A was arranged inside the vacuum chamber 2. An electric current of 8A was caused to flow only in the middle electromagnetic coil 203 to form a magnetic field having a predetermined pole, i.e., S-pole, without forming a magnetic field by each of the upper electromagnetic coil 201 and the lower electromagnetic coil 202.

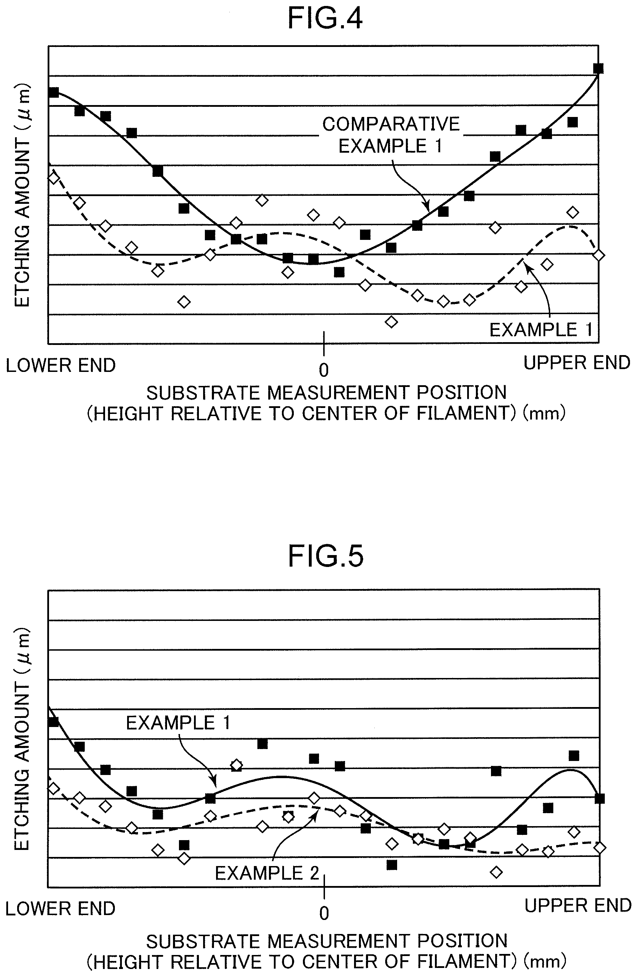

Fig. 4 is a graph showing a distribution of etching amounts of each workpiece W in each of Example 1 and Comparative Example 1. In Fig. 4, a horizontal axis denotes a height of a portion for measurement of each etching amount, and a vertical axis denotes each etching amount or depth of the portion for measurement. The height of the portion for measurement on the horizontal axis shows a position of each portion for measurement relative to the center of a filament in the up-down direction, and the center of each workpiece W in the up-down direction is set to zero. Etching amounts on the vertical axis are shown in such a manner that lower data has relatively more etching amounts or cutting amounts than upper data to make each cutting amount of the workpiece W visually recognizable. This showing way is applied to other graphs to be described later.

As shown in Fig. 4, in a configuration without a magnetic field around the filament 3 (Comparative Example 1), an etching amount (etching depth) by a central part or intermediate part 33 of the filament 3 that is likely to have a relatively high temperature depending on a temperature distribution of the filament 3 was larger than an etching amount by each of the upper end 31 and the lower end 32 of the filament, and thus, large variation in the etching amounts was seen. In contrast, in a configuration including magnetic fields formed respectively around the upper and lower ends of the filament 3 by the upper electromagnetic coil 201 and the lower electromagnetic coil 202 (Example 1), an etching amount by each of the upper end 31 and the lower end 32 increased and an etching amount by the intermediate part 33 slightly decreased, resulting in an improvement in the uniformity of the amounts in the up-down direction in comparison with Comparative Example 1. Besides, the magnetic fields formed in this manner increased each plasma density. This led to attainment of an increased average etching amount with respect to the workpiece W.

Fig. 5 is a graph showing a distribution of etching amounts of each workpiece W in each of Example 1 and Example 2. As shown in Fig. 5, a configuration including magnetic fields formed over a whole region in the up-down direction around the filament 3 (Example 2) by causing an electric current to flow in the middle electromagnetic coil 203 attained further increased uniformity of the etching amounts in the up-down direction in comparison with Example 1. Moreover, the magnetic fields formed in this manner increased plasma densities entirely. This led to attainment of a further increased average etching amount with respect to the workpiece W.

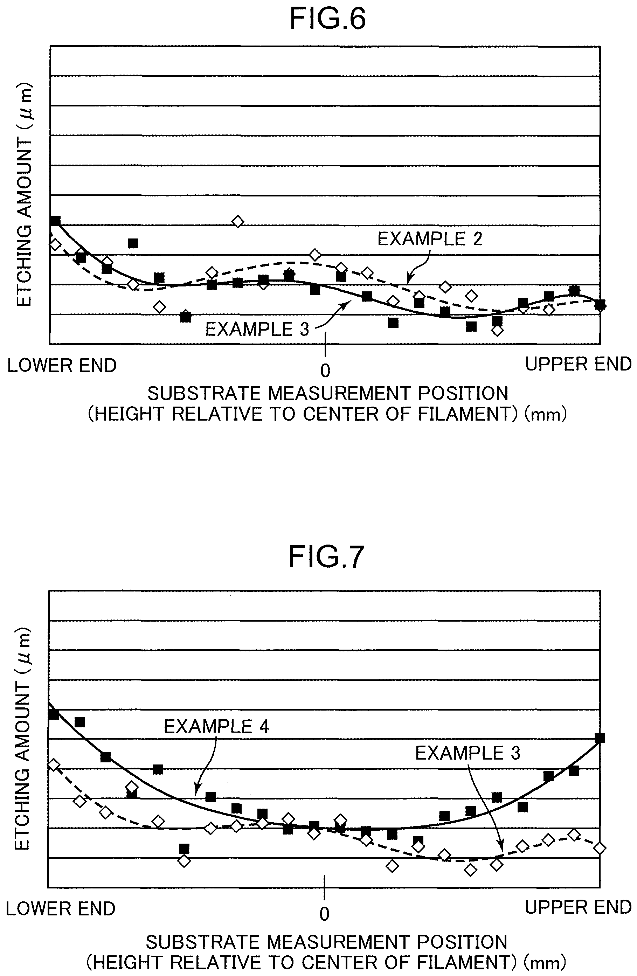

Fig. 6 is a graph showing a distribution of etching amounts of each workpiece W in each of Example 2 and Example 3. As shown in Fig. 6, a relatively smaller electric current to flow into the middle electromagnetic coil 203 than an electric current to flow into each of the upper electromagnetic coil 201 and the lower electromagnetic coil 202 (Example 3) in comparison with Example 2 showing the above-described good etching distribution rather increased the etching amount by the intermediate part 33. This resulted in attaining further increased uniformity of etching amounts in the up-down direction from the uniformity in Example 2. Reducing a magnetic field strength around the intermediate part 33 that is likely to have a relatively high temperature in the filament 3 in this manner is deduced to improve the balance of the magnetic fields respectively around the upper end 31 and the lower end 32 and increase the uniformity of plasma densities.

Fig. 7 is a graph showing a distribution of etching amounts of each workpiece W in each of Example 3 and Example 4. As shown in Fig. 7, reversing the polarity of the magnetic field by the middle electromagnetic coil 203 from the corresponding polarity in Example 3 showing the aforementioned achievement in forming the good etching distribution lead to a reduction in the etching amount by each of the upper end 31 and the lower end 32 of the filament 3. This resulted in slight deterioration in the uniformity. The result of the slight deterioration in the uniformity of plasma densities is deduced to come from mutual attraction between the magnetic field by the upper electromagnetic coil 201 and the magnetic field by the middle electromagnetic coil 203 and mutual attraction between the magnetic field by the lower electromagnetic coil 202 and the magnetic field by middle electromagnetic coil 203. However, Example 4 still shows a result that the uniformity in the up-down direction improved from the uniformity in the preceding Comparative Example 1 (Fig. 4). Furthermore, each plasma density increased in the same manner. This led to attainment of an increased average etching amount with respect to the workpiece W.

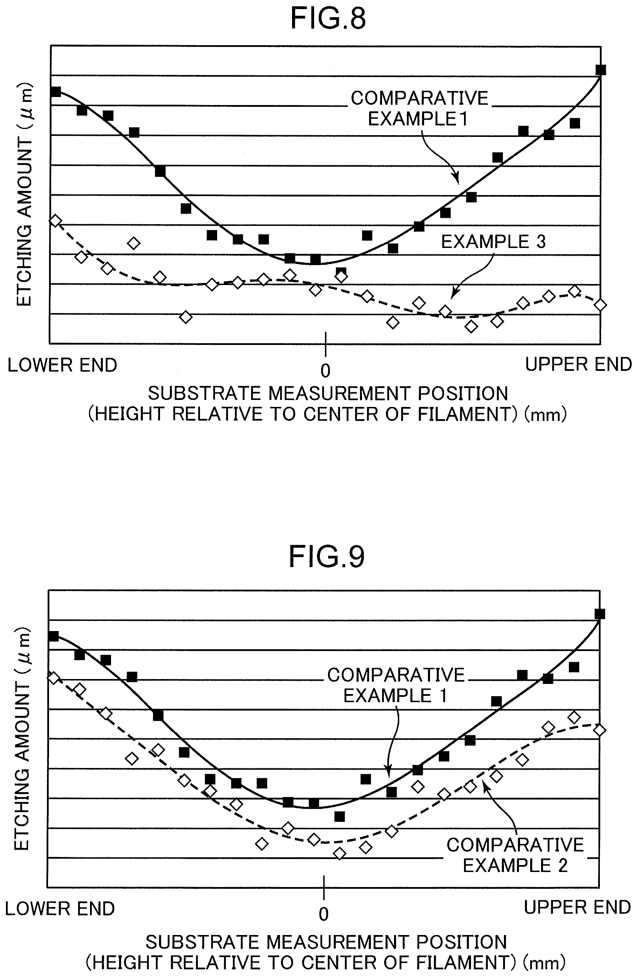

Fig. 8 is a graph showing a distribution of etching amounts of each workpiece W in each of Example 3 and Comparative Example 1. It can be understood from comparison of the graph about Example 3 with the graph about Comparative Example 1 that the uniformity of etching amounts in the up-down direction greatly improved. Moreover, the magnetic fields had an influence on an increase in each plasma density in Example 3. This led to attainment of an increased average etching amount with respect to the workpiece W.

Fig. 9 is a graph showing a distribution of etching amounts of each workpiece W in each of Comparative Example 1 and Comparative Example 2 to be compared with each Example. To form magnetic fields around the associated filament 3, such magnetic fields are desirably formed around the upper end 31 and the lower end 32, respectively, each being likely to have a relatively lower temperature than a temperature of the intermediate part 33. In this respect, a configuration including a magnetic field formed only around the intermediate part 33 like Comparative Example 2 in Fig. 9 was found to make it difficult to improve the uniformity (reduce variation) even with expectation for an increase in an etching amount from an etching amount in Comparative Example 1.

### Simulation results

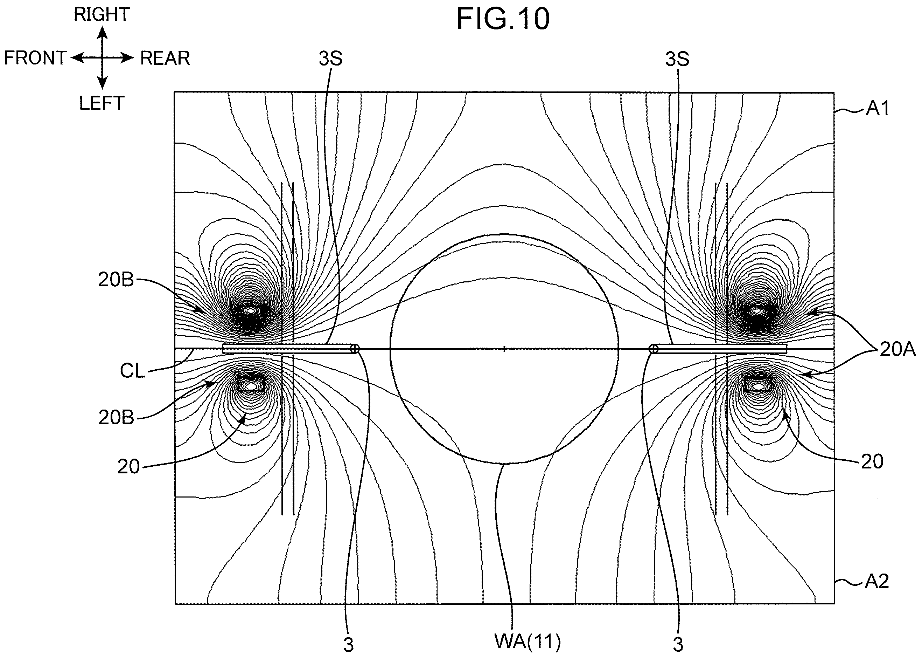

Next, Examples covered by the present invention will be described with reference to a magnetic field distribution in the vacuum chamber 2. Fig. 10 is a plan view of a magnetic field distribution around the workpieces W in each Example in the present invention, the magnetic field distribution being based on magnetic field analysis simulation. Fig. 10 illustrates a magnetic field distribution A1 in Example 5 in an upper portion of the drawing and a magnetic field distribution A2 in Example 6 in a lower portion of the drawing across a reference line CL extending in the front-rear direction and passing each filament 3. Conditions in each of Example 5 and Example 6 will be described below.

### Example 5

The first magnetic field generating mechanism 20A and the second magnetic field generating mechanism 20B were arranged inside the vacuum chamber 2. In the first magnetic field generating mechanism 20A, the upper electromagnetic coil 201, the lower electromagnetic coil 202, and the middle electromagnetic coil 203 formed their respective magnetic fields each having a specific same pole, i.e., S-pole, around the associated filament 3. An electric current of 8A was caused to flow in each of the upper electromagnetic coil 201, the lower electromagnetic coil 202, and the middle electromagnetic coil 203. In contrast, in the second magnetic field generating mechanism 20B, the upper electromagnetic coil 201, the lower electromagnetic coil 202, and the middle electromagnetic coil 203 formed their respective magnetic fields each having a specific same pole, i.e., N-pole, around the associated filament 3. An electric current of 8A was caused to flow in each of the upper electromagnetic coil 201, the lower electromagnetic coil 202, and the middle electromagnetic coil 203. It is noted here that the polarity of each of the three electromagnetic coils 200 of the first magnetic field generating mechanism 20A differed from the polarity of each of the three electromagnetic coils 200 of the second magnetic field generating mechanism 20B.

### Example 6

The first magnetic field generating mechanism 20A and the second magnetic field generating mechanism 20B were arranged inside the vacuum chamber 2. In the first magnetic field generating mechanism 20A, the upper electromagnetic coil 201, the lower electromagnetic coil 202, and the middle electromagnetic coil 203 formed their respective magnetic fields each having a specific same pole, i.e., S-pole, around the associated filament 3. An electric current of 8A was caused to flow in each of the upper electromagnetic coil 201, the lower electromagnetic coil 202, and the middle electromagnetic coil 203. Similarly, in the second magnetic field generating mechanism 20B, the upper electromagnetic coil 201, the lower electromagnetic coil 202, and the middle electromagnetic coil 203 formed their respective magnetic fields each having a specific same pole, i.e., S-pole, around the associated filament 3. An electric current of 8A was caused to flow in each of the upper electromagnetic coil 201, the lower electromagnetic coil 202, and the middle electromagnetic coil 203. It is noted here that the polarity of each of the three electromagnetic coils 200 of the first magnetic field generating mechanism 20A was the same as the polarity of each of the three electromagnetic coils 200 of the second magnetic field generating mechanism 20B.

It is seen from Fig. 10 that the magnetic field polarity of the first magnetic field generating mechanism 20A differs from (are opposite to) the magnetic field polarity of the second magnetic field generating mechanism 20B in the magnetic field distribution A1 in Example 5. Thus, such magnetic fields were formed between the mechanisms as to have their respective magnetic force lines being continuous to each other. As a result, the magnetic fields act to enclose the processing space WA accommodating the workpieces W from the radially outside to the radially inside, thereby allowing the workpieces W each revolving in conjunction with rotation of the rotatable table 11 to be continuously exposed to the plasma. In contrast, the magnetic field polarity of the first magnetic field generating mechanism 20A is same as the magnetic field polarity of the second magnetic field generating mechanism 20B in the magnetic field distribution A2 in Example 6. Hence, the magnetic fields of the mechanisms repel against each other and are not in the form of enclosing the processing space WA unlike the foregoing. Even this configuration achieves an improvement in the uniformity of the plasma densities around the filament 3 in the up-down direction case by each magnetic field generating mechanism, and enables stable etching processing onto the workpieces W.

Conclusively, the ion bombardment device 1 according to the present invention includes at least one magnetic field generating mechanism 20 that is located opposite the workpieces W across the filament 3. The magnetic field generating mechanism 20 includes at least the upper electromagnetic coil 201 and the lower electromagnetic coil 202.

This configuration can increase a plasma density in a region facing the upper end 31 of the associated filament 3 in the first magnetic field by the upper electromagnetic coil 201 and increase a plasma density in a region facing the lower end 32 of the filament in the second magnetic field by the lower electromagnetic coil 202, and hence can reduce variation in the plasma densities in the extension direction of the filament 3. This consequently succeeds in reducing variation in etching amounts on the surface of each workpiece W in the extension direction.

Besides, in the embodiment, the upper electromagnetic coil 201 has a polarity and the lower electromagnetic coil 202 has a polarity, the polarities being same so that a magnetic force line passing the upper end 31 and falling within the first magnetic field and the magnetic force line passing the lower end 32 and falling within the second magnetic field face in a same direction corresponding to a processing direction being a direction, perpendicularly intersecting the extension direction, in which the magnetic field generating mechanism 20 and the workpieces W are connected to each other.

In this configuration, the polarity of the first magnetic field around the upper end 31 of the filament 3 and the polarity of the second magnetic field around the lower end 32 of the filament are the same, and thus, the configuration allows the magnetic fields in the regions for the opposite ends of the filament 3 to have approximately the same shape and can further reduce variation in plasma densities in the extension direction of the filament 3. Even in a case where the filament 3 has a relatively short dimension, the configuration avoids forming strong magnetic force lines to attract each other between the first magnetic field and the second magnetic field in the up-down direction, and thus achieves stabilization of plasma distributions in the extension direction.

In the embodiment, the filament 3 further has the intermediate part 33 located between the upper end 31 and the lower end 32, and the magnetic field generating mechanism 20 further includes the middle electromagnetic coil 203. The middle electromagnetic coil 203 is located between the upper electromagnetic coil 201 and the lower electromagnetic coil 202 in the extension direction, and generates a middle magnetic field in a region incorporating the intermediate part 33 of the associated filament 3.

The configuration enables the middle magnetic field by the middle electromagnetic coil 203 to prevent a large fluctuation in the plasma density in the region facing the intermediate part 33 of the filament 3 due to the first magnetic field and the second magnetic field, and then achieves stabilization of the magnetic field distribution around the filament 3 in the extension direction.

In the embodiment, the upper electromagnetic coil 201 has a polarity, the lower electromagnetic coil 202 has a polarity, and the middle electromagnetic coil 203 has a polarity, the polarities being desirably same so that a magnetic force line passing the one end and falling within the first magnetic field, a magnetic force line passing the other end and falling within the second magnetic field, and a magnetic force line passing the intermediate part and falling within the middle magnetic field face in a same direction corresponding to the processing direction or front-rear direction.

The configuration achieves stabilization of the magnetic field distribution around the filament 3 in the extension direction by making the magnetic force lines respectively passing the upper end 31, the intermediate part 33, and the lower end 32 of the filament 3 face in the same direction. This consequently stabilizes the plasma distributions in the extension direction, and succeeds in further reducing variation in the etching amounts on the surface of each workpiece W.

In the embodiment, the middle electromagnetic coil 203 may have a magnetic force which is smaller than a magnetic force of the upper electromagnetic coil 201 and smaller than a magnetic force of the lower electromagnetic coil 202.

The configuration achieves further stabilization of the plasma distributions in the extension direction by making the magnetic field strength relatively smaller around the intermediate part 33 that is likely to have a relatively higher temperature than the temperature of each of the upper end 31 and the lower end 32 in the filament 3.

In the embodiment, the magnetic field generating mechanism 20 desirably includes the first magnetic field generating mechanism 20A and the second magnetic field generating mechanism 20B.

This configuration encourages the ion bombardment processing or etching processing onto each workpiece W by forming two plasma regions by the two filaments 3 located around the workpieces W. Further, arrangement of the associated magnetic field generating mechanisms 20 (20A and 20B) peculiar to the filaments 3 respectively leads to a success in increasing each plasma density and increasing the uniformity of the plasma densities in the extension direction, and further reducing variation in the distributions of the etching amounts of each workpiece W.

In the embodiment, the upper electromagnetic coil 201 of the first magnetic field generating mechanism 20A has a polarity and the lower electromagnetic coil 202 of the first magnetic field generating mechanism 20A has a polarity, the polarities being same so that a magnetic force line passing the upper end 31 of the first filament 3A and falling within the first magnetic field of the first magnetic field generating mechanism 20A and a magnetic force line passing the lower end 32 of the first filament 3A and falling within the second magnetic field of the first magnetic field generating mechanism 20A face in a same direction corresponding to a direction, perpendicularly intersecting an extension direction of the first filament 3A, in which the first magnetic field generating mechanism 20A and the workpieces W are connected to each other. Besides, the upper electromagnetic coil 201 of the second magnetic field generating mechanism 20B has a polarity and the lower electromagnetic coil 202 of the second magnetic field generating mechanism 20B has a polarity, the polarities being same so that a magnetic force line passing the upper end 31 of the second filament 3B and falling within the first magnetic field of the second magnetic field generating mechanism 20B and a magnetic force line passing the lower end 32 of the second filament 3B and falling within the second magnetic field of the second magnetic field generating mechanism 20B face in a same direction corresponding to a direction, perpendicularly intersecting an extension direction of the second filament 3B, in which the second magnetic field generating mechanism 20B and the workpieces W are connected to each other. The polarity of each of the upper electromagnetic coil 201 and the lower electromagnetic coil 202 of the first magnetic field generating mechanism 20A and the polarity of each of the upper electromagnetic coil 201 and the lower electromagnetic coil 202 of the second magnetic field generating mechanism 20B are opposite to each other.

In this configuration, the two magnetic field generating mechanisms 20A, 20B respectively generate the magnetic fields having polarities being opposite to each other to thereby respectively form magnetic force lines attracting each other between the magnetic fields (magnetic field distribution A1 in Fig. 10), and thus, the configuration achieves stabilization of the etching processing onto the workpieces W.

In the embodiment, each of the upper electromagnetic coil 201 and the lower electromagnetic coil 202 includes an electromagnetic coil having a center line extending in a direction, perpendicularly intersecting the extension direction of the filament 3, in which the magnetic field generating mechanism 20 and the workpieces W are connected to each other. The ion bombardment device 1 further includes a coil power source 20S that generates the first magnetic field and the second magnetic field by supplying a flow of the electric current to each of the magnetic field generating mechanism 20, and the upper electromagnetic coil 201 and the lower electromagnetic coil 202.

The configuration enables facilitated formation of the magnetic fields respectively around the upper end 31 and the lower end 32 of the filament 3 by causing the coil power source 20S to supply the flow of the electric current to each electromagnetic coil.

In the embodiment, the ion bombardment device 1 includes a pair of upper and lower filament electrodes 3S. The upper electromagnetic coil 201 and the lower electromagnetic coil 202 are arranged to surround the pair of filament electrodes 3S respectively.

This configuration reliably enables formation of the magnetic fields respectively around the upper end 31 and the lower end 32 of the filament 3 by arranging associated electromagnetic coils 200 relative to the pair of filament electrodes 3S respectively connected to the upper end 31 and the lower end 32 of the filament 3.

An ion bombardment processing method according to the embodiment is a method for cleaning a surface of each workpiece W. The processing method includes: supporting each workpiece W by a rotatable table 11 located in an inner space S of a vacuum chamber 2; arranging at least one filament 3 to extend in a predetermined extension direction in the inner space S and face the workpiece W; providing at least one magnetic field generating mechanism 20 to be located opposite the workpiece W across the filament 3, the at least one magnetic field generating mechanism 20 including an upper electromagnetic coil 201 that generates a first magnetic field in a region incorporating an upper end 31 of the at least one filament 3 and an upper electromagnetic coil 201 that generates a second magnetic field in a region incorporating a lower end 32 of the at least one filament 3 opposite to the upper end 31 in the extension direction; heating the at least one filament 3 by applying a heating voltage between the upper end 31 and the lower end 32 of the at least one filament; applying a discharge voltage between an anode (the vacuum chamber 2) exposed to the inner space S and the at least one filament 3; generating plasma by applying the discharge voltage between the at least one filament 3 having been heated and the anode; and cleaning the surface of the workpiece W by irradiating the surface with ions contained in the plasma while increasing a density of the plasma around each of the upper end 31 and the lower end 32 of the at least one filament 3 in at least the first magnetic field and the second magnetic field.

The method can increase a plasma density in a region facing the upper end 31 of the associated filament 3 in the first magnetic field by the upper electromagnetic coil 201 and increase a plasma density in a region facing the lower end 32 of the filament in the second magnetic field by the lower electromagnetic coil 202, and hence can reduce variation in the plasma densities in the extension direction of the filament 3. This consequently succeeds in reducing variation in etching amounts on the surface of each workpiece W in the extension direction. The features in the ion bombardment device 1 can constitute a part of the ion bombardment processing method.

Heretofore, the embodiment of the present invention has been described, but is a mere example, and thus, the present invention should not be limitedly construed. The present invention can cover, for example, the following modified embodiments.

In the present invention, each workpiece W or substrate may be made of insulating material without limitation to conductive material. One filament 3 and one magnetic field generating mechanism 20 may be arranged in the inner space S of the vacuum chamber 2, or three or more filaments and three or more mechanisms may be arranged in the inner space S.

Although the magnetic field generating mechanism 20 including the plurality of electromagnetic coils 200 is described in the embodiment, the magnetic field generating mechanism 20 may include a permanent magnet to serve as a magnetic field generator in place of each electromagnetic coil. In this case, in the same manner as each electromagnetic coil 200, a ring-shaped permanent magnet may be arranged, or a block-shaped permanent magnet may be arranged above the upper electromagnetic coil 201, below the lower electromagnetic coil 202, or other place.

The direction in which each filament 3 extends is not limited to the up-down direction, and the filament may horizontally extend depending on a shape of the vacuum chamber 2, an ion bombardment processing onto the filament 3, or other factor.

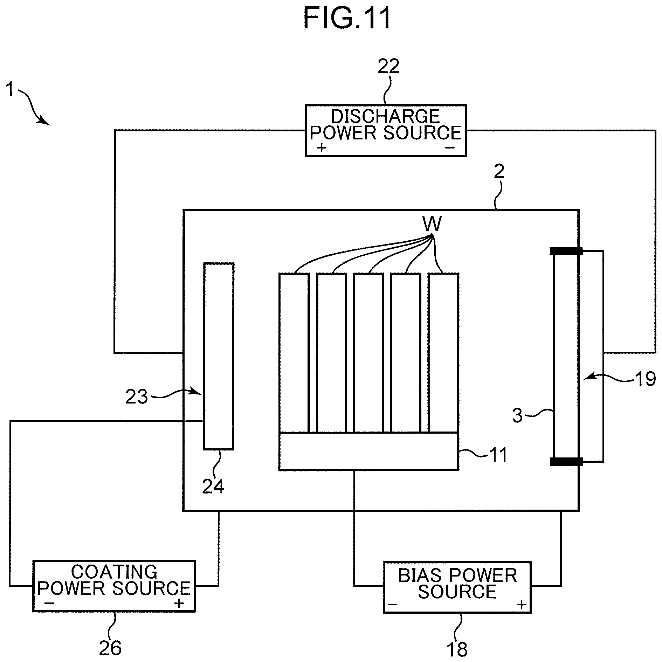

Fig. 11 is a side view of an ion bombardment device 1 according to a modified embodiment of the present invention. In the modified embodiment, the ion bombardment device 1 additionally includes a vacuum coating element 23 in comparison with the preceding embodiment (Fig. 1). The vacuum coating element 23 includes a coating evaporation source 24 located in the vacuum chamber 2, and a coating power source 26. The coating evaporation source 24 may serve as an anode with respect to the filament 3 in place of the vacuum chamber 2. The coating evaporation source 24 does not necessarily need to face workpieces W.

A part of argon ions contained in the plasma is accelerated to move toward the workpieces W located in front of the coating evaporation source 24 in response to application of a negative bias voltage to each of the workpieces W, and etches a surface of each workpiece. In use of the coating evaporation source 24 as the anode in the ion bombardment device 1 in this manner, each workpiece W may be subjected to coating processing after the ion bombardment processing. In this case, the coating evaporation source 24 is adoptable as a cathode in the coating processing. The coating processing to be executed to the workpiece W after the ion bombardment processing may include a spattering way, an arc ion plating way, or other way.

The present invention provides an ion bombardment device that is configured to clean a surface of a substrate by irradiating the surface with ions. The ion bombardment device includes a vacuum chamber, a substrate support, at least one filament, an anode, a discharge power source, a filament heating power source, and at least one magnetic field generating mechanism. The vacuum chamber defines an inner space inside the vacuum chamber. The substrate support is located in the inner space to support the substrate. The at least one filament extends in a predetermined extension direction in the inner space and faces the substrate. The at least one filament has one end and an other end opposite to the one end in the extension direction. The anode is exposed to at least the inner space. The discharge power source applies a discharge voltage between the at least one filament and the anode. The filament heating power source heats the filament by applying a heating voltage between the one end and the other end of the at least one filament. The at least one magnetic field generating mechanism is located opposite the substrate across the filament. The at least one magnetic field generating mechanism includes a first magnetic field generator that generates a first magnetic field in a region incorporating the one end of the at least one filament and a second magnetic field generator that generates a second magnetic field in a region incorporating the other end of the at least one filament.

The configuration can increase a plasma density around each of the one end and the other end of the filament in the first magnetic field by the first magnetic field generator and in the second magnetic field by the second magnetic field generator, and hence can reduce variation in the plasma densities in the extension direction of the filament. This consequently succeeds in reducing variation in the etching amounts on the surface of the substrate in the extension direction.

In the configuration, the first magnetic field generator has a polarity and the second magnetic field generator has a polarity, the polarities being desirably same so that a magnetic force line passing the one end and falling within the first magnetic field and a magnetic force line passing the other end and falling within the second magnetic field face in a same direction corresponding to a processing direction being a direction, perpendicularly intersecting the extension direction, in which the at least one magnetic field generating mechanism and the substrate are connected to each other.

In this configuration, the polarity of the first magnetic field around the one end of the filament and the polarity of the second magnetic field around the other end of the filament are the same, and thus, the configuration allows the magnetic fields in the regions for the opposite ends of the filament to have approximately the same shape and can further reduce variation in the plasma densities in the extension direction of the filament. Even in a case where the filament has a relatively short dimension, the configuration avoids forming strong magnetic force lines to attract each other between the first magnetic field and the second magnetic field, and thus achieves stabilization of plasma distributions in the extension direction.

In the configuration, the at least one filament desirably further has an intermediate part located between the one end and the other end, and the at least one magnetic field generating mechanism desirably further includes at least one middle magnetic field generator that is located between the first magnetic field generator and the second magnetic field generator in the extension direction and that generates a middle magnetic field in a region incorporating the intermediate part of the at least one filament.

The configuration enables the middle magnetic field by the middle magnetic field generator to prevent a large fluctuation in the plasma density in the region facing the intermediate part of the filament due to the first magnetic field and the second magnetic field, and then achieves further stabilization of the magnetic field distribution around the filament in the extension direction.

In the configuration, the first magnetic field generator has a polarity, the second magnetic field generator has a polarity, and the middle magnetic field generator has a polarity, the polarities being desirably same so that a magnetic force line passing the one end and falling within the first magnetic field, a magnetic force line passing the other end and falling within the second magnetic field, and a magnetic force line passing the intermediate part and falling within the middle magnetic field face in a same direction corresponding to a processing direction being a direction, perpendicularly intersecting the extension direction, in which the at least one magnetic field generating mechanism and the substrate are connected to each other.

The configuration achieves stabilization of the magnetic field distribution around the filament in the extension direction by making the magnetic force lines respectively passing the one end, the intermediate part, and the other end of the filament face in the same direction. This consequently stabilizes the plasma distributions in the extension direction, and succeeds in further reducing variation in the etching amounts on the surface of the substrate.

In the configuration, the middle magnetic field generator desirably has a magnetic force which is smaller than a magnetic force of the first magnetic field generator and smaller than a magnetic force of the second magnetic field generator.

The configuration achieves further stabilization of the plasma distributions in the extension direction by making the magnetic field strength relatively smaller around the intermediate part that is likely to have a relatively higher temperature than the temperature of each of the one end and the other end in the filament.

In the configuration, the at least one filament desirably includes: a first filament; and a second filament arranged in such a manner that the substrate is placed between the first filament and the second filament in a direction perpendicularly intersecting the extension direction. The at least one magnetic field generating mechanism desirably includes: a first magnetic field generating mechanism that generates a magnetic field around the first filament; and a second magnetic field generating mechanism that is arranged in such a manner that the substrate is placed between the first magnetic field generating mechanism and the second magnetic field generating mechanism in the direction perpendicularly intersecting the extension direction, and generates a magnetic field around the second filament.

This configuration encourages the ion bombardment processing or etching processing onto the substrate by forming two plasma regions by the two filaments located around the substrate. Further, arrangement of the associated magnetic field generating mechanisms peculiar to the filaments leads to a success in increasing each plasma density and increasing the uniformity of the plasma in the extension direction, and further reducing variation in the distributions of the etching amounts of the substrate.

In the configuration, a first magnetic field generator of the first magnetic field generating mechanism has a polarity and a second magnetic field generator of the first magnetic field generating mechanism has a polarity, the polarities being desirably same so that a magnetic force line passing one end of the first filament and falling within a first magnetic field of the first magnetic field generating mechanism and a magnetic force line passing an other end of the first filament and falling within a second magnetic field of the first magnetic field generating mechanism face in a same direction corresponding to a direction, perpendicularly intersecting the extension direction, in which the first magnetic field generating mechanism and the substrate are connected. A first magnetic field generator of the second magnetic field generating mechanism has a polarity and a second magnetic field generator of the second magnetic field generating mechanism has a polarity, the polarities being desirably same so that a magnetic force line passing one end of the second filament and falling within a first magnetic field of the second magnetic field generating mechanism and a magnetic force line passing an other end of the second filament and falling within a second magnetic field of the second magnetic field generating mechanism face in a same direction corresponding to a direction, perpendicularly intersecting the extension direction, in which the second magnetic field generating mechanism and the substrate are connected to each other. The polarity of each of the first magnetic field generator and the second magnetic field generator of the first magnetic field generating mechanism and the polarity of each of the first magnetic field generator and the second magnetic field generator of the second magnetic field generating mechanism are desirably opposite to each other.

In this configuration, the two magnetic field generating mechanisms respectively generate the magnetic fields having polarities being opposite to each other to thereby respectively form magnetic force lines attracting each other between the magnetic fields, and thus, the configuration achieves stabilization of the etching processing onto the substrate.

In the configuration, each of the first magnetic field generator and the second magnetic field generator of the at least one magnetic field generating mechanism desirably includes an electromagnetic coil having a center line extending in a direction, perpendicularly intersecting the extension direction, in which the at least one magnetic field generating mechanism and the substrate are connected to each other. The at least one magnetic field generating mechanism desirably further has a coil power source that generates the first magnetic field and the second magnetic field by supplying a flow of an electric current to each of the electromagnetic coil of the first magnetic field generator and the electromagnetic coil of the second magnetic field generator.

The configuration enables facilitated formation of the magnetic fields respectively around the one end and the other end of the filament by causing the coil power source to supply the flow of the electric current to each electromagnetic coil.

The configuration desirably further includes: a pair of electrodes respectively connected to the one end and the other end of the at least one filament to apply the heating voltage. The electromagnetic coil of the first magnetic field generator desirably surrounds one electrode of the pair of electrodes and the electromagnetic coil of the second magnetic field generator surrounds the other electrode of the pair of electrodes.

This configuration reliably enables formation of the magnetic fields respectively around the one end and the other end of the filament by arranging associated electromagnetic coils relative to the pair of electrodes respectively connected to the one end and the other end of the filament.

The present invention provides an ion bombardment processing method for cleaning a surface of a substrate. The ion bombardment processing method includes: supporting the substrate by a substrate support located in an inner space of a vacuum chamber; arranging at least one filament to extend in a predetermined extension direction in the inner space and face the substrate; providing at least one magnetic field generating mechanism to be located opposite the substrate across the filament, the at least one magnetic field generating mechanism including a first magnetic field generator that generates a first magnetic field in a region incorporating one end of the at least one filament and a second magnetic field generator that generates a second magnetic field in a region incorporating an other end of the at least one filament opposite to the one end in the extension direction; heating the at least one filament by applying a heating voltage between the one end and the other end of the at least one filament; generating plasma by applying a discharge voltage between an anode exposed to at least the inner space and the at least one filament; and cleaning the surface of the substrate by irradiating the surface with ions contained in the plasma while increasing a density of the plasma around each of the one end and the other end of the at least one filament in at least the first magnetic field and the second magnetic field.

The method can increase a plasma density around each of the one end and the other end of the filament in the first magnetic field by the first magnetic field generator and in the second magnetic field by the second magnetic field generator, and hence can reduce variation in the plasma densities in the extension direction of the filament. This consequently succeeds in reducing variation in the etching amounts on the surface of the substrate in the extension direction.

The present invention can provide an ion bombardment device and an ion bombardment processing method for a reduction in variation in etching amounts on a surface of a substrate by reducing variation in plasma densities in a vacuum chamber in an apparatus including a filament serving as an electrode.

## Claims

1. An ion bombardment device that is configured to clean a surface of a substrate by irradiating the surface with ions, the ion bombardment device comprising:
a vacuum chamber defining an inner space inside the vacuum chamber;
a substrate support located in the inner space to support the substrate;
at least one filament extending in a predetermined extension direction in the inner space and facing the substrate, and having one end and an other end opposite to the one end in the extension direction;
an anode exposed to at least the inner space;
a discharge power source that applies a discharge voltage between the at least one filament and the anode;
a filament heating power source that heats the filament by applying a heating voltage between the one end and the other end of the at least one filament; and
at least one magnetic field generating mechanism that is located opposite the substrate across the filament, and includes a first magnetic field generator that generates a first magnetic field in a region incorporating the one end of the at least one filament and a second magnetic field generator that generates a second magnetic field in a region incorporating the other end of the at least one filament.

2. The ion bombardment device according to claim 1, wherein the first magnetic field generator has a polarity and the second magnetic field generator has a polarity, the polarities being same so that a magnetic force line passing the one end and falling within the first magnetic field and a magnetic force line passing the other end and falling within the second magnetic field face in a same direction corresponding to a processing direction being a direction, perpendicularly intersecting the extension direction, in which the at least one magnetic field generating mechanism and the substrate are connected to each other.

3. The ion bombardment device according to claim 1 or 2, wherein the at least one filament further has an intermediate part located between the one end and the other end, and
the at least one magnetic field generating mechanism further includes at least one middle magnetic field generator that is located between the first magnetic field generator and the second magnetic field generator in the extension direction and that generates a middle magnetic field in a region incorporating the intermediate part of the at least one filament.

4. The ion bombardment device according to claim 3, wherein the first magnetic field generator has a polarity, the second magnetic field generator has a polarity, and the middle magnetic field generator has a polarity, the polarities being same so that a magnetic force line passing the one end and falling within the first magnetic field, a magnetic force line passing the other end and falling within the second magnetic field, and a magnetic force line passing the intermediate part and falling within the middle magnetic field face in a same direction corresponding to a processing direction being a direction, perpendicularly intersecting the extension direction, in which the at least one magnetic field generating mechanism and the substrate are connected to each other.

5. The ion bombardment device according to claim 4, wherein the middle magnetic field generator has a magnetic force which is smaller than a magnetic force of the first magnetic field generator and smaller than a magnetic force of the second magnetic field generator.

6. The ion bombardment device according to claim 1 or 2, wherein
the at least one filament includes:
a first filament; and
a second filament arranged in such a manner that the substrate is placed between the first filament and the second filament in a direction perpendicularly intersecting the extension direction, and
the at least one magnetic field generating mechanism includes:
a first magnetic field generating mechanism that generates a magnetic field around the first filament; and
a second magnetic field generating mechanism that is arranged in such a manner that the substrate is placed between the first magnetic field generating mechanism and the second magnetic field generating mechanism in the direction perpendicularly intersecting the extension direction, and generates a magnetic field around the second filament.

7. The ion bombardment device according to claim 6, wherein a first magnetic field generator of the first magnetic field generating mechanism has a polarity and a second magnetic field generator of the first magnetic field generating mechanism has a polarity, the polarities being same so that a magnetic force line passing one end of the first filament and falling within a first magnetic field of the first magnetic field generating mechanism and a magnetic force line passing an other end of the first filament and falling within a second magnetic field of the first magnetic field generating mechanism face in a same direction corresponding to a direction, perpendicularly intersecting the extension direction, in which the first magnetic field generating mechanism and the substrate are connected,
a first magnetic field generator of the second magnetic field generating mechanism has a polarity and a second magnetic field generator of the second magnetic field generating mechanism has a polarity, the polarities being same so that a magnetic force line passing one end of the second filament and falling within a first magnetic field of the second magnetic field generating mechanism and a magnetic force line passing an other end of the second filament and falling within a second magnetic field of the second magnetic field generating mechanism face in a same direction corresponding to a direction, perpendicularly intersecting the extension direction, in which the second magnetic field generating mechanism and the substrate are connected, and
the polarity of each of the first magnetic field generator and the second magnetic field generator of the first magnetic field generating mechanism and the polarity of each of the first magnetic field generator and the second magnetic field generator of the second magnetic field generating mechanism are opposite to each other.

8. The ion bombardment device according to claim 1 or 2, wherein each of the first magnetic field generator and the second magnetic field generator of the at least one magnetic field generating mechanism includes an electromagnetic coil having a center line extending in a direction, perpendicularly intersecting the extension direction, in which the at least one magnetic field generating mechanism and the substrate are connected to each other, and
the at least one magnetic field generating mechanism further has a coil power source that generates the first magnetic field and the second magnetic field by supplying a flow of an electric current to each of the electromagnetic coil of the first magnetic field generator and the electromagnetic coil of the second magnetic field generator.

9. The ion bombardment device according to claim 8, further comprising:
a pair of electrodes respectively connected to the one end and the other end of the at least one filament to apply the heating voltage, wherein
the electromagnetic coil of the first magnetic field generator surrounds one electrode of the pair of electrodes and the electromagnetic coil of the second magnetic field generator surrounds the other electrode of the pair of electrodes.

10. An ion bombardment processing method for cleaning a surface of a substrate, comprising:
supporting the substrate by a substrate support located in an inner space of a vacuum chamber;
arranging at least one filament to extend in a predetermined extension direction in the inner space and face the substrate;
providing at least one magnetic field generating mechanism to be located opposite the substrate across the at least one filament, the at least one magnetic field generating mechanism including a first magnetic field generator that generates a first magnetic field in a region incorporating one end of the at least one filament and a second magnetic field generator that generates a second magnetic field in a region incorporating an other end of the at least one filament opposite to the one end in the extension direction,
heating the at least one filament by applying a heating voltage between the one end and the other end of the at least one filament;
generating plasma by applying a discharge voltage between an anode exposed to at least the inner space and the at least one filament; and
cleaning the surface of the substrate by irradiating the surface with ions contained in the plasma while increasing a density of the plasma around each of the one end and the other end of the at least one filament in at least the first magnetic field and the second magnetic field.
